# EUROPEAN PATENT APPLICATION

(11) **EP 2 787 584 A1**
(43) Date of publication of application: **08.10.2014**
(21) Application number: 14382103.1
(22) Date of filing: 25.03.2014
(51) Int. Cl.: H02B 13/02, H02B 13/035, H02B 13/065, G01R 1/04, G01R 31/12, H01R 13/53

(54) **Electrical switchgear with a built-in connection system for connecting measuring equipment and injecting and sensing low-frequency and high-frequency signals**

(30) Priority: 04.04.2013 ES 201330398 U
(71) Applicant: Ormazabal Corporate Technology, A.I.E., 48340 Amorebieta-Etxano (Vizcaya) (ES)
(72) Inventor: Gilbert, Ian, Paul, 48340 Amorebieta-Etxano (Vizcaya) (ES); Uribe Lasuen, Mikel, 48340 Amorebieta-Etxano (Vizcaya) (ES); Hurtado Vicuña, Aritz, 48340 Amorebieta-Etxano (Vizcaya) (ES); Mulroy, Patrick, 48340 Amorebieta-Etxano (Vizcaya) (ES)
(74) Representative: Carpintero Lopez, Francisco

(57) **Abstract**

The present invention relates to electrical switchgear with a built-in connection system (7) for connecting measuring and/or communication equipment comprising: at least one high-voltage compartment (1, 1') incorporating electric power distribution elements (2); at least one low-voltage compartment (3) incorporating control, communication, diagnostic, measuring and protection elements (4); and at least one connecting point (6) for measuring and/or communication equipment (5); where the connecting point (6) for measuring and/or communication equipment (5) is installed in the low-voltage compartment (3), such that the measuring and/or communication equipment (5) can be connected without having to perform switching operations in the high-voltage power grid.

## Description

### Object of the Invention

The present invention is comprised in the field of the electric power distribution and transformation and more specifically relates to electrical switchgear including electric power distribution elements as well as power distribution grid control, measuring, communication, diagnostic and protection elements.

The electrical switchgear comprises several compartments where there are housed, on one hand, high-voltage distribution elements (for example cables, switches, fuses, etc.), and on the other hand, low-voltage control, communication, diagnostic, measuring and protection elements (for example control/protection relays, PLC modems, partial discharge measuring equipment, etc.), in a separate and electrically insulated manner. These latter elements are therefore accessible for operators without needing to cut off customers' electricity service or perform switching operations at different points of the grid, because the equipment (control/protection relays, PLC modems, partial discharge measuring equipment, etc.) is located in the low-voltage area of the switchgear.

### Background of the Invention

The electrical equipment or electrical switchgear used in electric power distribution installations for power grid switching and/or protection are made up of different compartments. On one hand, there are compartments such as the corresponding compartment for busbars, fuses, grid line connection, elements performing the corresponding switching and protection functions, i.e., acting like a switch, disconnect switch, grounding disconnect switch, etc., in summary compartments incorporating distribution elements. On the other hand, there are compartments corresponding to the control, measuring and protection elements configured for measuring and controlling the state of at least some of said electric power distribution elements, such that these latter elements allow controlling the flow of electric power and thus serving to both control power distribution and protect the different elements and equipment forming the distribution system.

The need to increase the quality/continuity of electricity service leads to automation in power grids, meaning that the use of equipment which allows performing grid supervision and control functions is increasingly more necessary and widespread.

Electronic relays, which can perform functions such as, for example, overcurrent protection, fault or short circuit detection, presence and absence of voltage, etc., can be mentioned among the control, measuring and protection elements that can be integrated in said switchgear. The relays and other control, measuring and protection elements are sometimes installed separately from the rest of the electrical switchgear. Racks or drawers integrating said control, measuring and protection elements are therefore used. These racks are usually assembled on the switchgear itself or in wall racks as an added element.

There are some measuring elements, such as partial discharge measuring equipment for example, that are permanently installed (when continuous monitoring is involved) or that can be temporarily connected (for periodic measurements when periodic monitoring is involved) in the high-voltage grid cable compartment. The installation of this partial discharge measuring equipment at said connecting point means accessing part of the electrical switchgear under high-voltage, which entails the drawback of having to cut off service at the point of the installation or performing a switching operation in the grid in order to supply zero voltage to that area as a security measure while the tasks for connecting said equipment last, being able to cut off power supply to consumers under low-voltage. In practice, the detection of partial discharges is very useful for determining if the insulation of electrical equipment is starting to degrade, and it is therefore advisable to on a regular basis check partial discharge activity in electrical equipment to improve the electric power supply quality.

On the other hand, examples of voltage and intensity signal sensors which are installed in the high-voltage cable compartment itself are also known, but these sensors are integrated in the electrical switchgear itself, factory installed, fitted and tested such that field assembly and connecting tasks are eliminated, eliminating mistakes in the installation of measuring means and preventing cutting off the power supply, as well as reducing the installation manual labor cost. Intensity and voltage signals that are sensed are conditioned and processed in electronic data acquisition equipment for protection, measurement and/or control, said sensors being connected to that end to this acquisition equipment which is installed in a low-voltage compartment by means of wiring. The solutions considered in patent documents ES2174754B1 and WO2010146086A1 can be mentioned as examples. However, the signals from the high-voltage side are not accessible for other purposes, such as for example, *in situ* power voltage or frequency measurement. Furthermore, nor is the *in situ* high-frequency and low-frequency signal injection/sensing of the high-voltage side for communications, grid diagnosis, partial discharge measurement, etc., possible.

### Description of the Invention

The electrical switchgear object of the invention applies to the field of electric power distribution. This electrical switchgear comprises electric power distribution elements (for example, busbars, fuses, grid line connection, equipment performing the corresponding switching and protection functions, i.e., switch, disconnect switch, grounding disconnect switch, etc.), all housed in at least one high-voltage compartment; and control, measurement, communication, diagnostic and protection elements (for example, electronic relays, partial discharge measuring equipment, communication signal transmitter/receiver, etc.) housed inside at least one low-voltage compartment, configured for controlling the state of at least some of said electric power distribution elements, such that the components integrating the electric power distribution system are measured, controlled and protected.

The present invention solves the drawbacks mentioned above in the state of the art, providing electrical switchgear comprising several compartments, whereby there are arranged in a separate and insulated manner, on one hand the high-voltage electric power distribution elements and on the other hand the low-voltage control, measuring, communication, diagnostic and protection elements which operators can on a regular basis access to perform maintenance tasks and start-up tasks, and to take periodic measurements, etc. It is therefore unnecessary to cut off service or perform a switching operation under high-voltage of the installation to perform said tasks because operators access a compartment in a safer manner under low-voltage, and therefore it is not necessary to perform a switching operation in the grid so that customers do not experience unexpected power failures that can further entail electrical equipment aging or damage, thus improving the quality of power supply.

In this sense, by means of this invention operators can perform *in situ* the measuring tasks (such as, for example, measuring partial discharges, voltage, frequency, etc.), high-frequency and low-frequency signals injection/sensing tasks, grid diagnosis tasks, etc., on a regular basis, even in distribution elements or parts of the power distribution grid that are online (in service) either through equipment permanently installed in the installations or through portable equipment that is connected/disconnected by the operator to perform periodic or isolated tasks. Therefore, it is possible to help avoid risks and perform suitable installation maintenance through partial discharge measurement and analysis. In summary, implementing rigorous control can save a great deal of time and money and prevent risk situations derived from an insulation failure under high-voltage.

According to the invention, the connection of the equipment for measuring voltage, partial discharges or signal injection/sensing through a PLC in the low-voltage compartment is performed through at least one connecting point forming part of the built-in connection system of the electrical switchgear object of the present invention.

The connection system comprises at least one coupling, which is provided with a coupling piece suitable for being connected to the high-voltage live part of the power grid under electrical safety and insulation conditions, such as in the high-voltage cable compartment for example, where the coupling piece can be inserted in a detachable high-voltage cable terminal or connector. To that end, the coupling piece can be made up of a leak-tight encapsulation that can comprise a first end which is connected to the detachable connector by the free end of the latter, such as for example by the free end of a T-connector or by the free end of a coupling device such as that claimed in ES1075987U. One coupling, which can be both a capacitive coupling and an inductive coupling, can be arranged for each phase of the installation.

The coupling comprises at least one signal input/output whereby connection with the power grid is performed. It can thus comprise a high-frequency signal input/output and another low-frequency signal input/output. On the other hand, said coupling comprises a high-voltage/low-voltage signal conditioning circuit for adapting the signals exchanged with the measuring equipment, communication equipment, etc.

The connection system comprises at least one connecting point in the low-voltage compartment mentioned above. This connecting point is associated with the coupling by means of wiring, for example through coaxial cables, said connecting point in turn comprising at least one connector, such as BNC connectors for example, for connecting the measuring equipment, high-frequency and low-frequency signal injection/sensing equipment, communication equipment, etc.

The possibility of the compartment incorporating the control, measuring, communication, diagnostic and protection elements being able to be assembled independently and separately from the compartment incorporating the distribution elements, such as a wall rack, for example, has been contemplated. Finally, it has been envisaged that the measuring and/or communication equipment can be installed in the low-voltage compartment both permanently (continuous monitoring) and periodically (periodic monitoring).

### Description of the Drawings

To complement the description that is being made and for the purpose of aiding to better understand the features of the invention according to a preferred practical embodiment thereof, a set of drawings is attached as an integral part of said description in which the following is depicted with an illustrative and non-limiting character:
Figure 1 shows a perspective view of the electrical switchgear, where the high-voltage compartments (1 and 1') and the low-voltage compartment (3) can be seen on one hand, and according to a preferred embodiment of the invention the low-voltage compartment (3) is assembled on the high-voltage compartment (1), and where the assembly of the coupling (8) in the high-voltage cables (12) through a T-connector or terminal (15) can be seen on the other hand.
Figure 2 shows a perspective view of an installation with the electrical switchgear of Figure 1, where the assembly of the low-voltage compartment (3) on the high-voltage compartments (1) can be seen, the compartment (3) comprising a connecting point (6).
Figure 3 shows a detail of the low-voltage compartment (3) of Figure 2, where the connecting point (6) comprising at least one connector (13) for connecting the measuring and/or communication equipment (5), etc., can be seen.
Figure 4 shows a perspective view of the coupling (8) comprising at least one signal input/output (9, 10) and a coupling piece (11) for being connected to the high-voltage live part through a terminal (15) in T.
Figure 5 shows the single-line diagram of the connection system (7), where the coupling (8), the high-voltage/low-voltage signal conditioning circuit (14) and the connecting point (6) are shown.
Figure 6 shows a perspective view of a distribution installation according to another preferred embodiment of the invention, where the low-voltage compartment (3) and the high-voltage compartment (1, 1') are installed separately, the low-voltage compartment (3) being assembled like a wall rack.

### Preferred Embodiment of the Invention

Several preferred embodiments are described below in reference to the aforementioned drawings without limiting or reducing the scope of protection of the present invention.

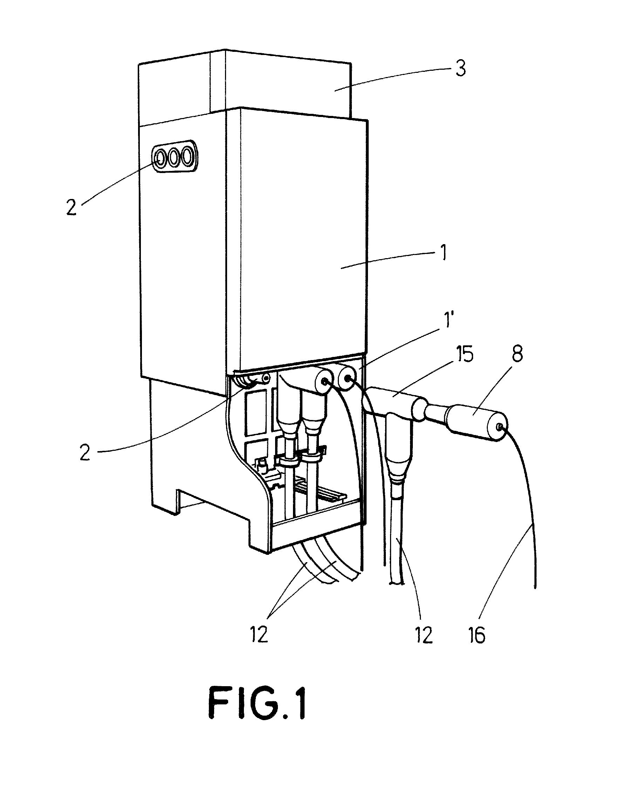

According to one embodiment of the invention, as shown in Figures 1, 2 and 3, the electrical switchgear comprises at least one low-voltage compartment (3) assembled on at least one high-voltage compartment (1, 1'). Control, measuring, communication, diagnostic and protection elements (4), such as electronic relays, partial discharge measuring equipment, modems, etc., are arranged inside said low-voltage compartment (3), whereas the high-voltage distribution elements (2), such as, for example, busbars, fuses, grid line connection, switch, disconnect switch, grounding disconnect switch, etc., are incorporated inside the high-voltage compartments (1, 1'). Therefore, the high-voltage distribution elements (2) and the low-voltage control, communication, diagnostic, measuring and protection elements (4) are integrated in the same electrical switchgear but are insulated from one another in different compartments, such that handling the control, communication, diagnostic, measuring and protection elements (4) does not involve cutting off the service of the installation or performing a switching operation under high-voltage because the operator must not access a compartment with elements under high-voltage. In this sense, the performance of start-up, measuring, control and online (live) maintenance tasks is enabled.

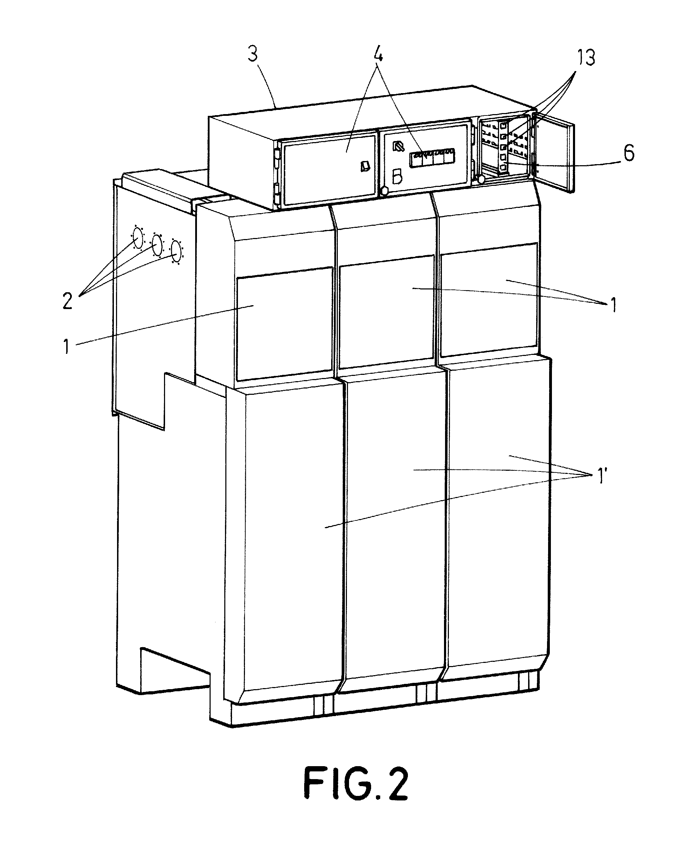

Through the low-voltage compartment (3), the electrical switchgear of the invention allows performing various measurement and control operations, such as the partial discharge measurement. To that end, as shown in Figures 2, 3, 5 and 6, the low-voltage compartment (3) comprises at least one connecting point (6) where measuring and/or communication equipment (5) can be connected. In this sense, the electrical switchgear comprises a connection system (7) comprising said connecting point (6) arranged in the low-voltage compartment (3).

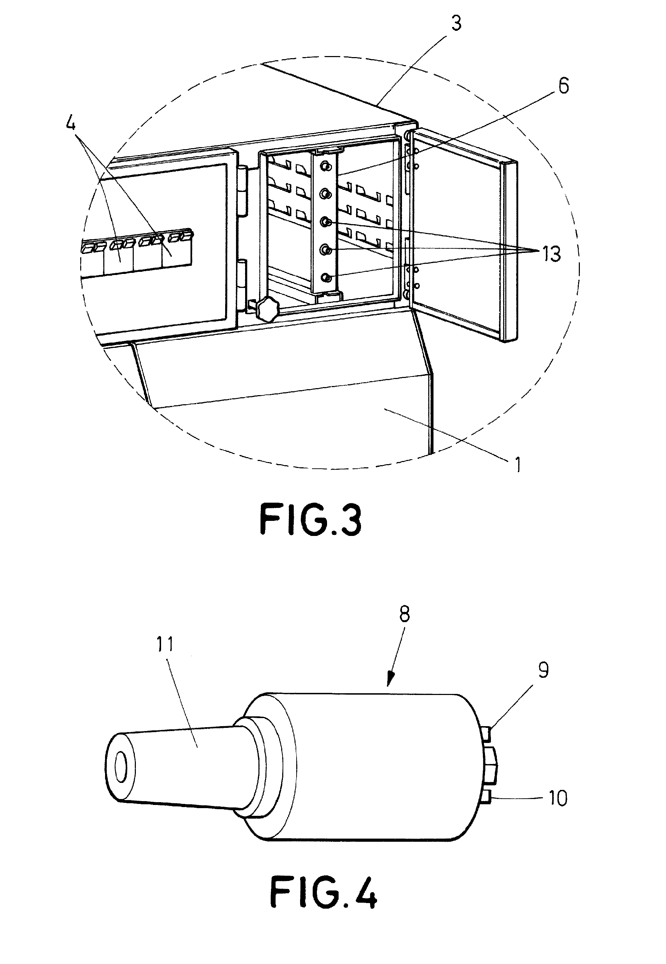

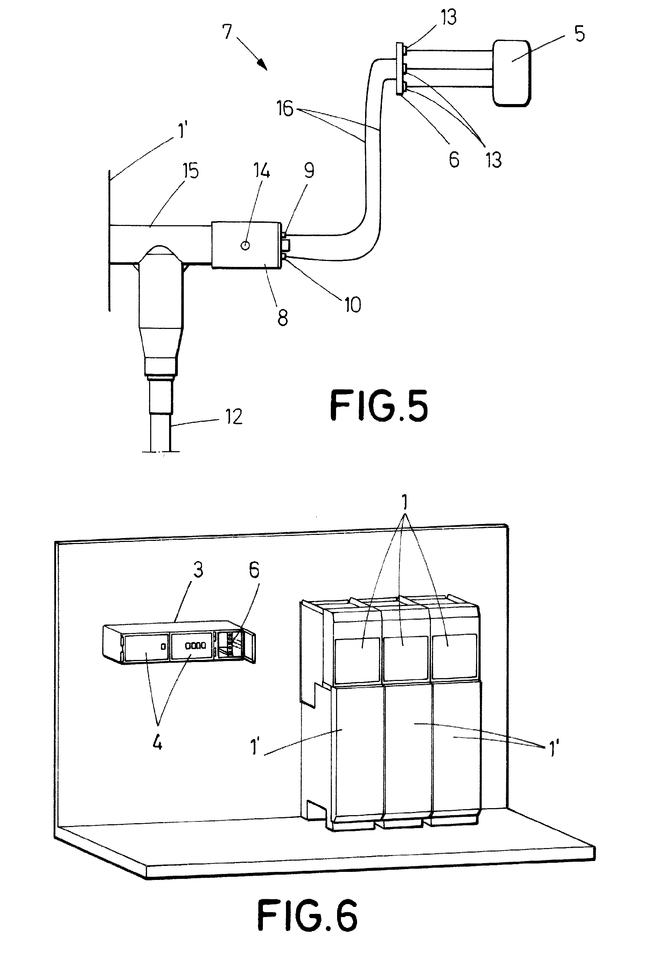

As shown in Figures 4 and 5, the connection system (7), comprises a coupling (8) which can be capacitive or inductive, the latter comprising a coupling piece (11) which allows connecting said coupling (8) to a high-voltage live part (12) of the installation, said coupling (8) therefore being installed in a high-voltage compartment (1'). As shown in Figure 1, the coupling piece (11) can be plugged into a detachable connector or terminal (15) of a high-voltage cable (12). To that end, the coupling piece (11) can be made up of a leak-tight encapsulation which can comprise a first end which is connected to the detachable connector (15) by the free end of the latter, such as by the free end of a T-connector for example. One coupling (8) can be arranged for each phase of the installation.

The connecting point (6) located in the low-voltage compartment (3) and the coupling (8) located in the high-voltage compartment (1') can be associated or connected through coaxial cables (16), as depicted in Figure 5. Likewise, as seen in Figure 4, the coupling (8) comprises at least one (high-frequency and low-frequency) signal input/output (9, 10) whereby the coupling (8) is connected with the connecting point (6) by means of the coaxial cables (16). Likewise, as shown in Figure 5, the coupling (8) comprises a high-voltage/low-voltage signal conditioning circuit (14) for adapting the signals exchanged with the measuring and/or communication equipment (5), etc., which can be connected at the connecting point (6).

As shown in Figure 3, said connecting point (6) can comprise at least one female-type connector (13), such as BNC connectors for example, for connecting said measuring and/or communication equipment (5).

Finally, depending on the installation in which the electrical switchgear is going to be assembled, the low-voltage compartment (3) and the high-voltage compartment (1, 1') can be assembled one on top of the other (Figure 2) or they can be independent and assembled separately, the compartment (3) in the latter case being assembled like a wall rack, as shown in Figure 6.

## Claims

1. Electrical switchgear with a built-in connection system (7) for connecting measuring and/or communication equipment comprising:
- at least one high-voltage compartment (1, 1') incorporating electric power distribution elements (2),
- at least one low-voltage compartment (3) incorporating control, communication, diagnostic, measuring and protection elements (4), and
- at least one connecting point (6) for measuring and/or communication equipment (5),
**characterized in that** the connecting point (6) for measuring and/or communication equipment (5) is installed in the low-voltage compartment (3), such that the measuring and/or communication equipment (5) can be connected without having to perform switching operations in the high-voltage power grid.

2. Electrical switchgear according to claim 1, **characterized in that** the built-in connection system (7) comprises at least one coupling (8) in turn provided with at least one signal input/output (9, 10).

3. Electrical switchgear according to claim 2, **characterized in that** the coupling (8) comprises at least one high-frequency signal input/output (9) and at least one low-frequency signal input/output (10).

4. Electrical switchgear according to any one of the preceding claims 2 or 3, **characterized in that** the coupling (8) comprises a coupling piece (11) suitable for being connected to a high-voltage live part (12) of the power distribution grid.

5. Electrical switchgear according to claim 4, **characterized in that** the coupling piece (11) comprises a leak-tight encapsulation that can be connected to a detachable connector or terminal (15) of a high-voltage cable (12).

6. Electrical switchgear according to claim 5, **characterized in that** the terminal (15) has a T-shaped configuration.

7. Electrical switchgear according to any of claims 2-4, **characterized in that** the coupling (8) comprises a high-voltage/low-voltage signal conditioning circuit (14).

8. Electrical switchgear according to any of claims 2-4 and 7, **characterized in that** the coupling (8) is capacitive.

9. Electrical switchgear according to any of claims 2-4 and 7, **characterized in that** the coupling (8) is inductive.

10. Electrical switchgear according to claim 1, **characterized in that** the connecting point (6) comprises at least one female-type connector (13).

11. Electrical switchgear according to claim 10, **characterized in that** the female-type connector (13) comprises at least one BNC connector.

12. Electrical switchgear according to any of the preceding claims 2-9, **characterized in that** the connecting point (6) and the coupling (8) are connected by means of coaxial cables (16).

13. Electrical switchgear according to any of the preceding claims, **characterized in that** the high-voltage and low-voltage compartments (1, 1', 3) are independent and assembled separately.

14. Electrical switchgear according to any of the preceding claims, **characterized in that** the measuring and/or communication equipment (5) is permanently installed in the low-voltage compartment (3).

15. Electrical switchgear according to any of claims 1-13, **characterized in that** the measuring and/or communication equipment (5) is periodically installed in the low-voltage compartment (3).
